# EUROPEAN PATENT APPLICATION

(11) **EP 4 664 459 A1**
(43) Date of publication of application: **17.12.2025**
(21) Application number: 25155499.4
(22) Date of filing: 03.02.2025
(51) Int. Cl.: G11C 11/16, G11C 11/18, G11C 7/24

(54) **PROBABILISTIC DEVICE THAT SUPPORTS RANDOM BIT GENERATION**

(30) Priority: 14.06.2024 KR 20240077345
(71) Applicant: Samsung Electronics Co., Ltd., Suwon-si, Gyeonggi-do 16677 (KR); Korea Advanced Institute of Science and Technology, Daejeon (KR)
(72) Inventor: PARK, Byong Guk, Daejeon (KR); HAN, Dong Hyeon, Daejeon (KR); PARK, Jeong-Heon, 16677 Suwon-si, Gyeonggi-do (KR)
(74) Representative: Kuhnen & Wacker Patent- und Rechtsanwaltsbüro PartG mbB

(57) **Abstract**

A probabilistic bit device includes a spin orbit torque (SOT) pattern, which contains a stacked combination of a ferromagnetic pattern having in-plane magnetic anisotropy and a conductive pattern on the ferromagnetic pattern, and a magnetic tunnel junction (MTJ) pattern on the SOT pattern. The MTJ pattern contains a stacked combination of a free magnetic pattern having perpendicular magnetic anisotropy, a barrier pattern, and a pinned magnetic pattern having perpendicular magnetic anisotropy. A controller is provided, which is configured to supply an in-plane current having a first magnitude and a magnetic field having a second magnitude to the SOT pattern, such that a desired probability that a magnetization direction of the free magnetic pattern is in a predetermined direction is achieved.

## Description

### REFERENCE TO PRIORITY APPLICATION

This application claims priority to Korean Patent Application No. 10-2024-0077345, filed June 14, 2024, the disclosure of which is hereby incorporated herein by reference.

### BACKGROUND

The present disclosure relates to a probabilistic bit device including a spin orbit torque (SOT)-based memory cell.

A magnetic memory device such as MRAM (Magnetic Random Access Memory) is a memory device that stores data therein using change in a resistance of a magnetic tunnel junction element. The resistance of the magnetic tunnel junction element depends on a magnetization direction of a free layer. For example, when the magnetization direction of the free layer is the same as that of a pinned layer, the magnetic tunnel junction element may have a low resistance value. But, when the magnetization direction of the free layer is opposite to that of the pinned layer, the magnetic tunnel junction element may have a high resistance value. When this characteristic is applied to the memory device, the magnetic tunnel junction element may represent data '0' when it has a low resistance value and may represent data '1' when it has a high resistance value.

A magnetic memory element that uses a spin transfer torque for a write operation that determines the magnetization direction of the free layer is referred to as a STT-MRAM (Spin Transfer Torque MRAM). A magnetic memory element that uses a spin orbit torque for a write operation that determines the magnetization direction of the free layer is referred to as a SOT-MRAM (Spin Orbit Torque MRAM).

The STT-MRAM may have an operating speed of approximately 50 to 100 nanoseconds and may have excellent data retention of more than 10 years. A spin polarization direction is perpendicular to the magnetization direction in the SOT-MRAM which may have an operation speed of 10 nanoseconds. Furthermore, the SOT-MRAM may have more stable durability because a write current path and a read current path are different from each other.

### SUMMARY

A technical purpose of the present disclosure is to provide a probabilistic bit device including a spin orbit torque-based memory cell that generates a random number.

Purposes according to the present disclosure are not limited to the above-mentioned purpose. Other purposes and advantages according to the present disclosure that are not mentioned may be understood based on following descriptions, and may be more clearly understood based on embodiments according to the present disclosure. Further, it will be easily understood that the purposes and advantages according to the present disclosure may be realized using means illustrated in the claims and combinations thereof.

According to some example embodiments, a probabilistic bit device includes a spin orbit torque pattern including a ferromagnetic pattern and a conductive pattern sequential stacked; and a magnetic tunnel junction pattern including a free magnetic pattern, a barrier pattern, and a pinned magnetic pattern sequentially stacked on the spin orbit torque pattern; and a controller configured to provide an in-plane current with a predetermined first magnitude and a magnetic field with a predetermined second magnitude to the spin orbit torque pattern in an in-plane direction parallel to an upper surface of the ferromagnetic pattern. The ferromagnetic pattern can have an in-plane magnetic anisotropy, and each of the pinned magnetic pattern and the free magnetic pattern may have perpendicular magnetic anisotropy. A magnetization direction of the pinned magnetic pattern is pinned, whereas a magnetization direction of the free magnetic pattern is variable. Advantageously, each of the first magnitude and the second magnitude may be controlled to correspond to a desired probability at which the magnetization direction of the free magnetic pattern is a specific direction.

According to some example embodiments, a magnetic memory device in a probabilistic bit device includes a memory cell including a ferromagnetic pattern, a conductive pattern, a free magnetic pattern, a barrier pattern, and a pinned magnetic pattern sequentially stacked; and a controller configured to provide an in-plane current and a magnetic field to the ferromagnetic pattern, wherein a magnetization direction of the ferromagnetic pattern is an in-plane direction, wherein a magnetization direction of the pinned magnetic pattern is fixed and is a perpendicular direction, and wherein a magnetization direction of the free magnetic pattern is a perpendicular direction and is variable based on the in-plane current and the magnetic field.

According to some example embodiments, a probabilistic bit device includes memory cells including a spin orbit torque pattern and a magnetic tunnel junction pattern stacked sequentially; and a controller configured to provide an in-plane current with a predetermined first magnitude and a magnetic field with a predetermined second magnitude to the spin orbit torque pattern, wherein the first magnitude and the second magnitude correspond to a probability at which a resistance of the magnetic tunnel junction pattern has a specific resistance value.

According to some example embodiments, a probabilistic bit device is provided, which includes a spin orbit torque (SOT) pattern containing a stacked combination of a ferromagnetic pattern having in-plane magnetic anisotropy and a conductive pattern on the ferromagnetic pattern, and a magnetic tunnel junction (MTJ) pattern on the SOT pattern. The MTJ pattern includes a stacked combination of a free magnetic pattern having perpendicular magnetic anisotropy, a barrier pattern, and a pinned magnetic pattern having perpendicular magnetic anisotropy. A controller is provided and is configured to supply an in-plane current having a first magnitude and a magnetic field having a second magnitude to the SOT pattern, such that a desired probability that a magnetization direction of the free magnetic pattern is in a predetermined direction is achieved. According to some embodiments, the in-plane current having the first magnitude and the magnetic field having the second magnitude are provided in an in-plane direction that is parallel to an upper surface of the ferromagnetic pattern.

### BRIEF DESCRIPTION OF DRAWINGS

The above and other aspects and features of the present disclosure will become more apparent by describing in detail embodiments thereof with reference to the attached drawings, in which:
FIG. 1 is a diagram for illustrating a probabilistic bit device according to some embodiments;
FIG. 2 is a diagram for illustrating anomalous Hall effect (AHE) voltage measurement in a memory cell of FIG. 1;
FIG. 3 is a diagram showing a relationship between a magnitude of an in-plane current and a normalized Hall resistance in the memory cell of FIG. 2;
FIG. 4 is a diagram showing a relationship between the magnitude of the in-plane current in the memory cell in FIG. 3 and a probability at which a magnetization direction of a magnetic tunnel junction pattern of the memory cell is in a parallel state;
FIG. 5 is a diagram showing a relationship between a magnitude of a magnetic field and the normalized Hall resistance in the memory cell of FIG. 2;
FIG. 6 is a diagram showing a relationship between the magnitude of the magnetic field in the memory cell in FIG. 5 and a probability at which a magnetization direction of a magnetic tunnel junction pattern of the memory cell is in a parallel state;
FIG. 7 is a diagram showing the normalized Hall resistance in the memory cell of FIG. 2;
FIG. 8 is a diagram showing a NIST (national institute of standards and technology) test result of the normalized Hall resistance in the memory cell of FIG. 2;
FIG. 9 is a diagram for illustrating a probabilistic state of a magnetic tunnel junction structure in FIG. 1;
FIGS. 10 to 13 are diagrams for illustrating a probabilistic bit device according to some embodiments;
FIG. 14 is a diagram for illustrating a probabilistic bit device according to some embodiments;
FIG. 15 is a diagram for illustrating a probabilistic bit device according to some embodiments;
FIG. 16 is a diagram for illustrating a cell array of a magnetic memory element according to some embodiments;
FIG. 17 is a diagram for illustrating a cell array of a magnetic memory element according to some embodiments; and
FIG. 18 is a diagram for illustrating a cell array of a magnetic memory element according to some embodiments.

### DETAILED DESCRIPTION OF EMBODIMENTS

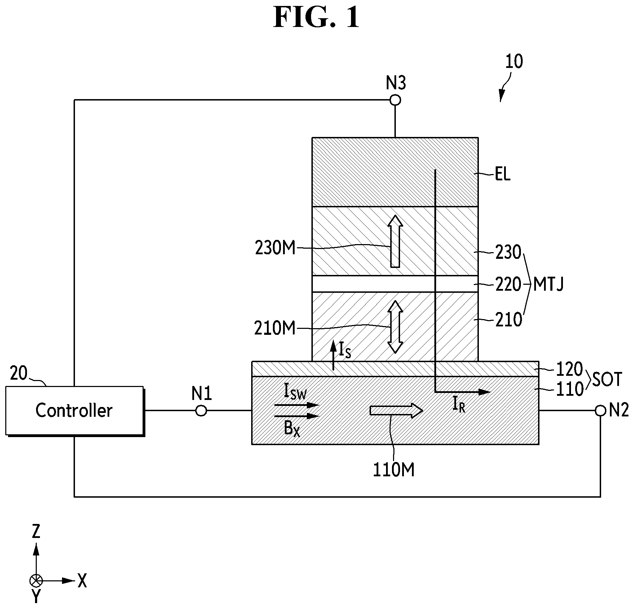

FIG. 1 is a diagram for illustrating a probabilistic bit device according to some embodiments, which includes a memory cell 10 and a controller 20. The memory cell 10 includes a spin orbit torque pattern SOT and a magnetic tunnel junction pattern MTJ. The spin orbit torque pattern SOT includes a ferromagnetic pattern 110 and a conductive pattern 120 that are sequentially stacked.

In some embodiments, the spin orbit torque pattern SOT may have a line shape extending in a first direction X. The first direction X may be a direction parallel to an upper surface of the spin orbit torque pattern SOT. Hereinafter, the first direction X and a second direction Y are parallel to the upper surface of the spin orbit torque pattern SOT, and intersect each other at a right angle. A third direction Z is a direction perpendicular to the upper surface of the spin orbit torque pattern SOT, and intersects the first direction X and the second direction Y at right angles. As used herein, the terms "upper" and "lower" are defined based on the third direction Z. An upward direction means a positive third direction Z, and a downward direction means a negative third direction Z.

The ferromagnetic pattern 110 may have in-plane magnetic anisotropy (IMA). A magnetization direction 110M of the ferromagnetic pattern 110 may be an in-plane direction that is parallel to the upper surface of the ferromagnetic pattern 110. Hereinafter, the in-plane direction refers to a direction parallel to the upper surface of the ferromagnetic pattern 110. The magnetization direction 110M of the ferromagnetic pattern 110 may be the first direction X.

The ferromagnetic pattern 110 may include a ferromagnetic material. The ferromagnetic pattern 110 may include at least one of, for example, iron (Fe), cobalt (Co), nickel (Ni), boron (B), silicon (Si), zirconium (Zr), platinum (Pt), terbium (Tb), palladium (Pd), copper (Cu), tungsten (W), and mixtures thereof. In contrast, the conductive pattern 120 may include, for example, a non-magnetic metal. The conductive pattern 120 may include, for example, at least one of platinum (Pt), tantalum (Ta), titanium (Ti), copper (Cu), tungsten (W), palladium (Pd), and mixtures thereof.

The magnetic tunnel junction pattern MTJ is formed on the spin orbit torque pattern SOT. The magnetic tunnel junction pattern MTJ includes a free magnetic pattern 210, a barrier pattern 220, and a pinned magnetic pattern 230 that are sequentially stacked. As shown, the conductive pattern 120 extends between the ferromagnetic pattern 110 and the free magnetic pattern 210.

The pinned magnetic pattern 230 may have perpendicular magnetic anisotropy (PMA); thus, the magnetization direction 230M of the pinned magnetic pattern 230 may be perpendicular to the in-plane direction. The magnetization direction 230M of the pinned magnetic pattern 230 may be a vertical direction, for example, the third direction Z. The pinned magnetic pattern 230 may have a pinned magnetization direction 230M regardless of whether an external magnetic field or an external electric field is applied.

Similarly, the free magnetic pattern 210 may have perpendicular magnetic anisotropy. But, the free magnetic pattern 210 may also have two alternative stable magnetization directions 210M parallel to the third direction Z, and these two magnetization directions 210M may be opposite to each other. The free magnetic pattern 210 may have a magnetization direction 210M (for example, a magnetization direction 210M as the positive third direction Z or the upward magnetization direction 210M) parallel to the magnetization direction 230M of the pinned magnetic pattern 230, or a magnetization direction 210M (for example, the magnetization direction 210M as the negative third direction Z or the downward magnetization direction 210M) anti-parallel to the magnetization direction 230M of the pinned magnetic pattern 230. The magnetization direction 210M of the free magnetic pattern 210 may be changed in response to application of an external magnetic field or an external electric field.

The magnetic tunnel junction pattern MTJ may store data therein by using a change in an electrical resistance based on the magnetization direction 230M of the pinned magnetic pattern 230 and the magnetization direction 210M of the free magnetic pattern 210. For example, when the magnetization direction 230M of the pinned magnetic pattern 230 and the magnetization direction 210M of the free magnetic pattern 210 are parallel to each other, the magnetic tunnel junction pattern MTJ has a relatively low resistance value, and may be treated as storing data 0 therein. Conversely, when the magnetization direction 230M of the pinned magnetic pattern 230 and the magnetization direction 210M of the free magnetic pattern 210 are anti-parallel to each other, the magnetic tunnel junction pattern MTJ may have a relatively high resistance value and may be treated as storing data 1 therein.

Hereinafter, a parallel state of the magnetic tunnel junction pattern MTJ may mean that the magnetization direction 230M of the pinned magnetic pattern 230 and the magnetization direction 210M of the free magnetic pattern 210 are parallel to each other (the magnetization direction 210M of the free magnetic pattern 210 is upward). An antiparallel state of the magnetic tunnel junction pattern MTJ may mean that the magnetization direction 230M of the pinned magnetic pattern 230 and the magnetization direction 210M of the free magnetic pattern 210 are anti-parallel to each other (the magnetization direction 210M of the free magnetic pattern 210 is a downward direction).

The pinned magnetic pattern 230 may include a ferromagnetic material. The pinned magnetic pattern 230 may include, for example, iron (Fe), cobalt (Co), nickel (Ni), boron (B), silicon (Si), zirconium (Zr), platinum (Pt), terbium (Tb), palladium (Pd), copper (Cu), tungsten (W), and mixtures thereof. Similarly, the free magnetic pattern 210 may include a ferromagnetic material. The free magnetic pattern 210 may include, for example, iron (Fe), cobalt (Co), nickel (Ni), boron (B), silicon (Si), zirconium (Zr), platinum (Pt), terbium (Tb), palladium (Pd), copper (Cu), tungsten (W), and mixtures thereof.

As shown, the barrier pattern 220 may extend between the free magnetic pattern 210 and the pinned magnetic pattern 230. The barrier pattern 220 may include a metal oxide having insulating ability. For example, the barrier pattern 220 may include at least one of aluminum oxide (AlOx), magnesium oxide (MgOx), tantalum oxide (TaOx), and zirconium oxide (ZrOx). Finally, an electrode EL may be formed on the magnetic tunnel junction pattern MTJ. The electrode EL may include at least one of a metal (e.g., tungsten, titanium, and/or tantalum) and a conductive metal nitride (e.g., titanium nitride, tantalum nitride, and/or tungsten nitride).

The controller 20 is connected to the memory cell 10. The controller 20 may be connected to a first node N1, a second node N2, and a third node N3 of the memory cell 10. Both opposing ends of the spin orbit torque pattern SOT opposite to each other in the first direction X may be connected to the first node N1 and the second node N2, respectively. For example, both opposite ends in the first direction X of the ferromagnetic pattern 110 may be connected to the first node N1 and the second node N2, respectively. The electrode EL may be formed on the magnetic tunnel junction pattern MTJ. The electrode EL may be connected to the third node N3. The controller 20 may be connected to the first node N1, the second node N2, and the third node N3.

Additional electronic elements may be respectively disposed between the controller 20 and the first node N1, between the controller 20 and the second node N2, and between the controller 20 and the third node N3. The electronic elements may include at least one of a transistor and a diode, for example. In addition, the controller 20 may perform write and read operations of the memory cell 10 by applying voltage or current to the first to third nodes N1, N2, and N3.

In particular, the controller 20 is configured to provide an in-plane current Isw to the spin orbit torque pattern SOT in the in-plane direction. For example, the controller 20 may provide the in-plane current Isw to the ferromagnetic pattern 110 in the in-plane direction parallel to the upper surface of the ferromagnetic pattern 110. The controller 20 may provide the in-plane current Isw to the ferromagnetic pattern 110 in the first direction X.

The in-plane current Isw may flow in the spin orbit torque pattern SOT. When the electrical conductivity of the conductive pattern 120 is greater than that of the ferromagnetic pattern 110, the in-plane current Isw may mainly flow into the conductive pattern 120. A spin current Is having polarization in the third direction Z may be generated by the in-plane current Isw. The spin current Is may include a spin current generated in the ferromagnetic pattern 110 by a spin Hall effect and an interfacial spin current generated at an interface between the ferromagnetic pattern 110 and the conductive pattern 120.

The spin current Is may flow in a direction (for example, the third direction Z) perpendicular to the interface between the spin orbit torque pattern SOT and the magnetic tunnel junction pattern MTJ so as to be applied to the free magnetic pattern 210. The spin current Is may apply the spin orbit torque to the free magnetic pattern 210 and induce magnetization reversal of the free magnetic pattern 210. That is, the magnetization state of the magnetic tunnel junction pattern MTJ may be a parallel or anti-parallel state. Accordingly, a write operation may be performed on the memory cell 10.

The controller 20 may also provide a magnetic field B_{X} to the spin orbit torque pattern SOT in the in-plane direction. The magnetic field B_{X} may be provided to the spin orbit torque pattern SOT using various methods. The controller 20 may provide the magnetic field B_{X} to the ferromagnetic pattern 110 in the first direction X. The magnetic field B_{X} may induce magnetization reversal of the free magnetic pattern 210. Accordingly, a write operation may be performed on the memory cell 10.

The controller 20 may also provide a constant voltage across the second node N2 and the third node N3 and measures a value of a read current I_{R} flowing from the third node N3 to the second node N2. Thus, a read operation may be performed on the memory cell 10.

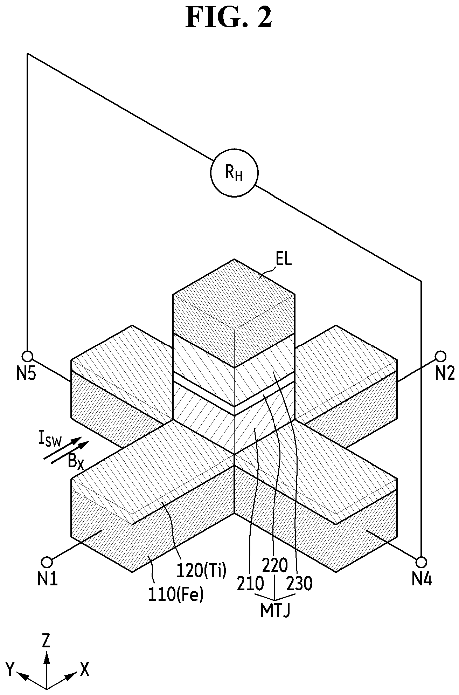

FIG. 2 is a diagram for illustrating anomalous Hall effect voltage measurement in the memory cell of FIG. 1. Referring to FIG. 2, the ferromagnetic pattern 110 is made of iron (Fe) and has a thickness of 2 nm. The conductive pattern 120 is made of titanium (Ti) and has a thickness of 3 nm. The free magnetic pattern 210 is made of CoFeB and has a thickness of 1 nm. The thickness is defined based on the third direction Z.

The ferromagnetic pattern 110 is formed in an epitaxial growth process. The ferromagnetic pattern 110 is deposited in a sputtering process on a single crystal substrate in a MgO (001) orientation at a temperature of about 200 degrees C. Each of the conductive pattern 120, the free magnetic pattern 210, and the barrier pattern 220 is deposited in a sputtering process at room temperature.

The spin orbit torque pattern SOT has a cross shape (hall bar shape). The spin orbit torque pattern SOT has a width of 5 µm in the first direction X and a width of 5 µm in the second direction Y, and extends in an elongate manner in the first direction X and the second direction Y. The magnetic tunnel junction pattern MTJ has an island structure with a width of 4 µm in the first direction X and a width of 4 µm in the second direction Y.

Both opposing ends of the spin orbit torque pattern SOT that are opposite to each other in the second direction Y may be connected to a fourth node N4 and a fifth node N5, respectively. The in-plane current Isw and the magnetic field B_{X} are applied from the first node N1 to the second node N2, and the Hall resistance RH is measured.

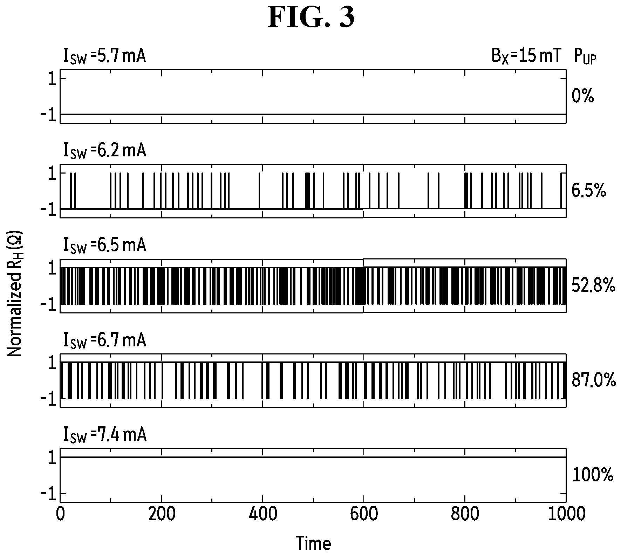

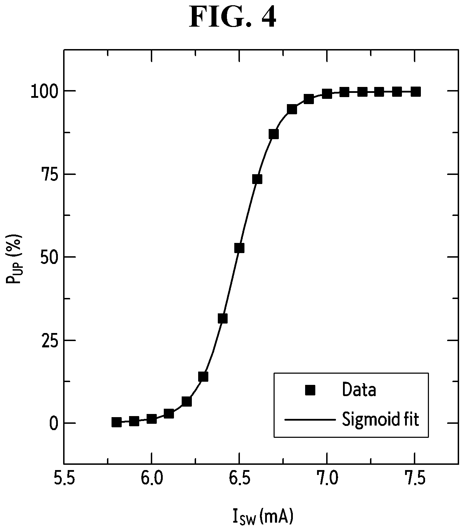

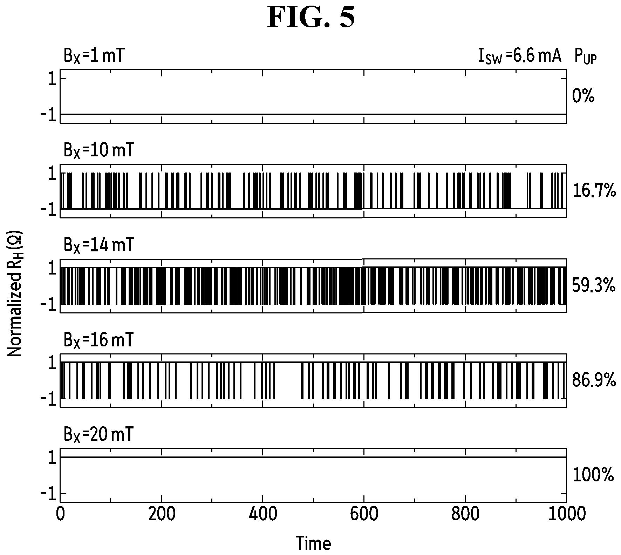

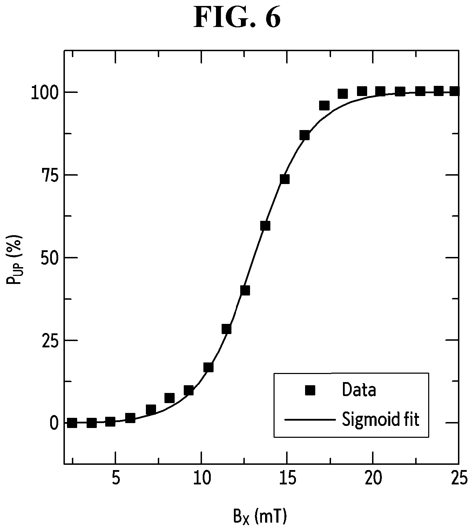

FIG. 3 is a diagram showing a relationship between a magnitude of the in-plane current and the normalized Hall resistance in the memory cell of FIG. 2; and FIG. 4 is a diagram showing a relationship between a magnitude of an in-plane current in the memory cell in FIG. 3 and a probability at which a magnetization direction of a magnetic tunnel junction pattern of the memory cell is in a parallel state. FIG. 5 is a diagram showing a relationship between the magnitude of the magnetic field and the normalized Hall resistance in the memory cell of FIG. 2; and FIG. 6 is a diagram showing a relationship between the magnitude of the magnetic field in the memory cell in FIG. 5 and the probability at which the magnetization direction of the magnetic tunnel junction pattern of the memory cell is in a parallel state.

When the magnetization direction of the magnetic tunnel junction pattern MTJ in FIG. 2 is in a parallel state, the normalized Hall resistance in FIG. 3 and FIG. 5 has 1. When the magnetization direction of the magnetic tunnel junction pattern MTJ in FIG. 2 is in an anti-parallel state, the normalized Hall resistance in FIG. 3 and FIG. 5 has -1. A probability P_{UP} that the magnetization direction of the magnetic tunnel junction pattern MTJ is in a parallel state means the probability P_{UP} that that the magnetization direction of the free magnetic pattern 210 is upward.

Referring to FIGS. 2 to 4, in a state in which the magnitude of the magnetic field BX applied in the in-plane direction X to the ferromagnetic pattern 110 is pinned to 15 mT, a probability P_{UP} that the magnetization direction of the free magnetic pattern 210 is upward varies depending on the magnitude of the in-plane current Isw applied to the ferromagnetic pattern 110 in the in-plane direction X.

Thus, as shown by FIG. 3, when the magnitude of the in-plane current Isw is 5.7 mA, the probability P_{UP} that the magnetization direction of the magnetic tunnel junction pattern MJT is in a parallel state is 0%. When the magnitude of the in-plane current Isw is 6.2 mA, the probability P_{UP} that the magnetization direction of the free magnetic pattern 210 is upward is 6.5%. When the magnitude of the in-plane current Isw is 6.5 mA, the probability P_{UP} that the magnetization direction of the free magnetic pattern 210 is upward is 52.8%. When the magnitude of the in-plane current Isw is 6.7 mA, the probability P_{UP} that the magnetization direction of the free magnetic pattern 210 is upward is 87%. When the magnitude of the in-plane current Isw is 7.4 mA, the probability P_{UP} that the magnetization direction of the free magnetic pattern 210 is upward is 100%. The probability P_{UP} that the magnetization direction of the free magnetic pattern 210 is upward based on the magnitude of the in-plane current Isw has a sigmoid function relationship. Accordingly, the magnitude of the in-plane current Isw applied to the ferromagnetic pattern 110 in the in-plane direction X may be controlled such that the probability P_{UP} that the magnetization direction of the free magnetic pattern 210 is upward may be controlled to a value in a range of 0% to 100%.

Referring to FIG. 2, FIG. 5, and FIG. 6, in a state in which the magnitude of the in-plane current Isw applied in the in-plane direction X to the ferromagnetic pattern 110 is pinned to 6.6 mA, the probability P_{UP} that the magnetization direction of the free magnetic pattern 210 is upward varies depending on the magnitude of the magnetic field B_{X} applied in the in-plane direction X to the ferromagnetic pattern 110.

Thus, as shown by FIG. 5, when the magnitude of the magnetic field B_{X} is 1mT, the probability P_{UP} that the magnetization direction of the free magnetic pattern 210 is upward is 0%. When the magnitude of the magnetic field B_{X} is 10mT, the probability P_{UP} that the magnetization direction of the free magnetic pattern 210 is upward is 16.7%. When the magnitude of the magnetic field B_{X} is 14mT, the probability P_{UP} that the magnetization direction of the free magnetic pattern 210 is upward is 59.3%. When the magnitude of the magnetic field B_{X} is 16mT, the probability P_{UP} that the magnetization direction of the free magnetic pattern 210 is upward is 86.9%. When the magnitude of the magnetic field B_{X} is 20mT, the probability P_{UP} that the magnetization direction of the free magnetic pattern 210 is upward is 100%. The probability P_{UP} that the magnetization direction of the free magnetic pattern 210 is upward based ono the magnitude of the magnetic field B_{X} has a sigmoid function relationship. Accordingly, the magnitude of the magnetic field B_{X} applied to the ferromagnetic pattern 110 in the in-plane direction X may be controlled such that the probability P_{UP} that the magnetization direction of the free magnetic pattern 210 is upward may be controlled to a value in a range of 0% to 100%.

In a probabilistic bit device according to some embodiments, the controller 20 may control at least one of the magnitude of the in-plane current Isw applied to the ferromagnetic pattern 110 in the in-plane direction X and the magnitude of the magnetic field B_{X} applied in the in-plane direction X to the ferromagnetic pattern 110, such that the probability at which the magnetization direction of the free magnetic pattern 210 is upward may be controlled. That is, the magnetization direction of the free magnetic pattern 210 may change based on the in-plane current Isw and the magnetic field B_{X}. The controller 20 may provide the in-plane current Isw having a predetermined first magnitude and the magnetic field B_{X} having a predetermined second magnitude to the ferromagnetic pattern 110. The first magnitude and the second magnitude may be pre-determined to correspond to a specific probability at which the magnetization direction of the free magnetic pattern 210 is upward.

For example, the first magnitude and the second magnitude may correspond to a probabilistically "random" 50% probability at which the magnetization direction of the free magnetic pattern 210 is in a specific direction (for example, upward). The controller 20 may provide the in-plane current Isw with the first magnitude and the magnetic field B_{X} the second magnitude to the ferromagnetic pattern 110 so that the probability at which the magnetization direction of the free magnetic pattern 210 is upward is 50%. Accordingly, the probability at which the magnetic tunnel junction pattern MTJ is in a specific state (for example, a parallel state) may be 50%. In other words, the probability at which the magnetic tunnel junction pattern MTJ will have a specific data (e.g., 0) or the probability at which the magnetic tunnel junction pattern MTJ will have a specific resistance value (e.g. a low resistance value) may be 50%.

The probabilistic bit device may generate a logic 0 or 1 depending on the magnetization direction 210M of the free magnetic pattern 210. For example, the probabilistic bit device may generate a logic 0 when the magnetization direction 210M of the free magnetic pattern 210 is downward. Alternatively, the probabilistic bit device may generate a logic 1 when the magnetization direction 210M of the free magnetic pattern 210 is upward. Therefore, the probabilistic bit device may output a logic 0 or 1 at the 50% probability.

At least one of the first magnitude and the second magnitude may vary depending on the ferromagnetic pattern 110, the conductive pattern 120, and the free magnetic pattern 210. At least one of the first magnitude and the second magnitude may be predetermined based on at least one of, for example, a material of the ferromagnetic pattern 110, a magnetization intensity of the ferromagnetic pattern 110, a thickness of the ferromagnetic pattern 110, a material of the conductive pattern 120, a thickness of the conductive pattern 120, a material of the free magnetic pattern 210, a magnetization intensity of the free magnetic pattern 210, and a thickness of the free magnetic pattern 210. For example, when the ferromagnetic pattern 110 is made of iron (Fe) and has a thickness of 2 nm, the conductive pattern 120 is made of titanium (Ti) and has a thickness of 3 nm, and the free magnetic pattern 210 is made of CoFeB and has a thickness of 1 nm, the first magnitude may be 6.6 mA and the second magnitude may be 13.5 mT.

The probabilistic bit device according to some embodiments may control the first magnitude and the second magnitude by adjusting the ferromagnetic pattern 110, the conductive pattern 120, and the free magnetic pattern 210, and thus may operate at relatively low power. Furthermore, the probabilistic bit device according to some embodiments may be manufactured at a temperature that is highly compatible with a general semiconductor process (e.g., a logic manufacturing process).

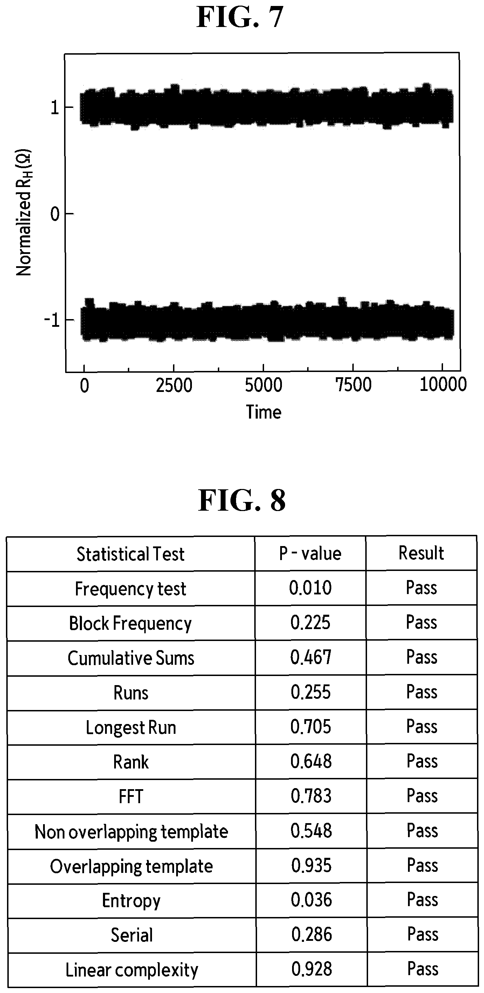

FIG. 7 is a diagram showing the normalized Hall resistance in the memory cell of FIG. 2; and FIG. 8 is a diagram showing the NIST (national institute of standards and technology) test results of the normalized Hall resistance in the memory cell of FIG. 2. Referring to FIG. 2 and FIG. 7, when the magnetic field B_{X} of 13.5 mT in the in-plane direction X is provided to the ferromagnetic pattern 110, and the in-plane current Isw of 6.6mA in the in-plane direction X is provided to the ferromagnetic pattern 110, a state where the magnetization direction 210M of the free magnetic pattern 210 is upward and a state where the magnetization direction 210M of the free magnetic pattern 210 is downward may be output at a ratio of about 50:50. In other words, the probability at which the magnetization direction 210M of the free magnetic pattern 210 is upward may be 50%. The probabilistic bit device including the memory cell 10 in FIG. 2 may output 0 or 1 at a probability of 50%. Referring to FIG. 8, the normalized Hall resistance in memory cell 10 in FIG. 2 passes all NIST tests. Therefore, the probabilistic bit device according to some embodiments including the memory cell 10 of FIG. 2 may be used as a random number generation device.

Advantageously, the probabilistic bit device according to some embodiments may generate a genuinely random number that essentially guarantees complete randomness. Furthermore, the probabilistic bit device according to some embodiments includes the spin orbit torque-based memory cell 10, and thus may operate in a faster operation manner.

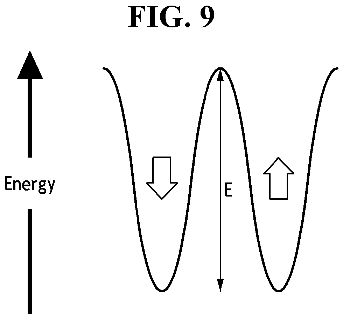

FIG. 9 is a diagram for illustrating a probabilistic state of the magnetic tunnel junction structure in FIG. 1. FIG. 9 is a diagram showing energy of the free magnetic pattern 210 in a stable state in FIG. 1. In FIG. 9, one of a downward arrow and an upward arrow indicates a state in which the magnetization direction 210M of the free magnetic pattern 210 is parallel to the magnetization direction 230M of the pinned magnetic pattern 230 (a state in which the magnetic tunnel junction pattern MTJ is in the parallel state), while the other thereof indicates a state in which the magnetization direction 210M of the free magnetic pattern 210 is antiparallel to the magnetization direction 230M of the pinned magnetic pattern 230 (a state in which the magnetic tunnel junction pattern MTJ is in the antiparallel state).

Referring to FIG. 1 and FIG. 9, there is an energy barrier between the parallel and anti-parallel states of the magnetic tunnel junction pattern MTJ. When the free magnetic pattern 210 is in an unstable state, a low energy barrier exists between the parallel and anti-parallel states of the magnetic tunnel junction pattern MTJ. Accordingly, the parallel and anti-parallel states of the magnetic tunnel junction pattern MTJ may randomly fluctuate and switch to each other every very short time of several ms to or ns. Furthermore, the energy barrier changes sensitively depending on the thickness of the free magnetic pattern 210, a size of the magnetic tunnel junction pattern MTJ, an operating temperature of the memory cell 10, etc.

On the contrary, the energy E of the free magnetic pattern 210 of the magnetic tunnel junction pattern MTJ according to some embodiments is stable at 20 kT or higher. Therefore, the magnetic tunnel junction pattern MTJ may stably maintain the parallel and anti-parallel states. That is, the probabilistic bit device according to some embodiments may stably generate and output the data.

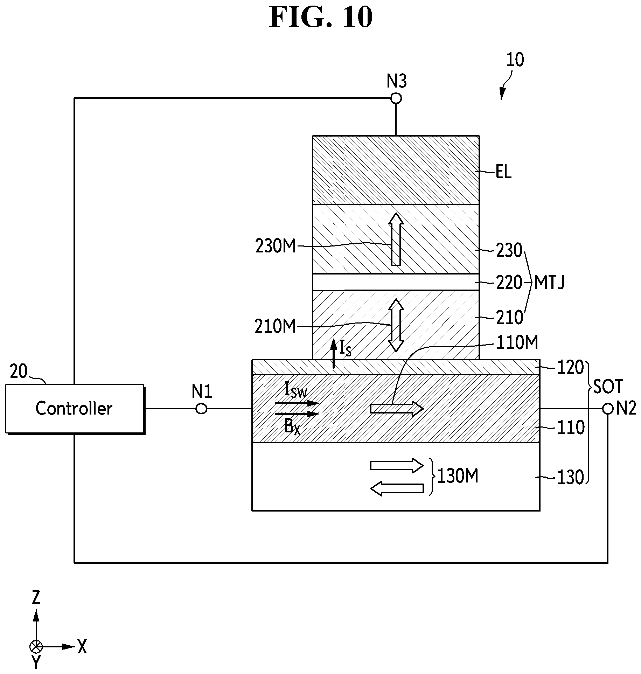

FIGS. 10 to 13 are diagrams for illustrating a probabilistic bit device according to some embodiments. For convenience of description, contents duplicate with those as described above using FIGS. 1 to 8 are briefly described or descriptions thereof are omitted. Referring to FIGS. 10 to 13, in a probabilistic bit device according to some embodiments, the spin orbit torque pattern SOT may further include an antiferromagnetic pattern 130. The ferromagnetic pattern 110 may be disposed between the conductive pattern 120 and the antiferromagnetic pattern 130.

The antiferromagnetic pattern 130 may have in-plane magnetic anisotropy. The magnetization direction 130M of the antiferromagnetic pattern 130 may be an in-plane direction X. The antiferromagnetic pattern 130 may fix the magnetization direction 110M of the ferromagnetic pattern 110. The antiferromagnetic pattern 130 may include an antiferromagnetic material. For example, the antiferromagnetic pattern 130 may include at least one selected from at least one of PtMn, IrMn, MnO, MnS, MnTe, MnF2, FeCl2, FeO, CoCl2, CoO, NiCl2, NiO and Cr, or a precious metal. The precious metal may include ruthenium (Ru), rhodium (Rh), palladium (Pd), osmium (Os), iridium (Ir), platinum (Pt), gold (Au), or silver (Ag).

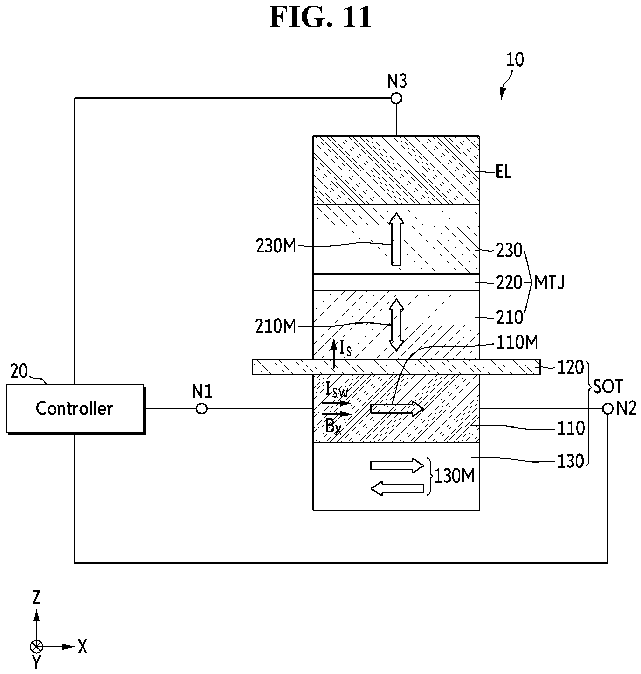

Referring to FIG. 10, in the probabilistic bit device according to some embodiments, the antiferromagnetic pattern 130 may extend in the first direction X. And, referring to FIG. 11, in the probabilistic bit device according to some embodiments, the antiferromagnetic pattern 130 and the ferromagnetic pattern 110 may be disposed on a portion of the conductive pattern 120. The antiferromagnetic pattern 130 and the ferromagnetic pattern 110 may be aligned with a magnetic tunnel junction pattern MTJ. The antiferromagnetic pattern 130 and the ferromagnetic pattern 110 may overlap with the magnetic tunnel junction pattern MTJ in the third direction Z.

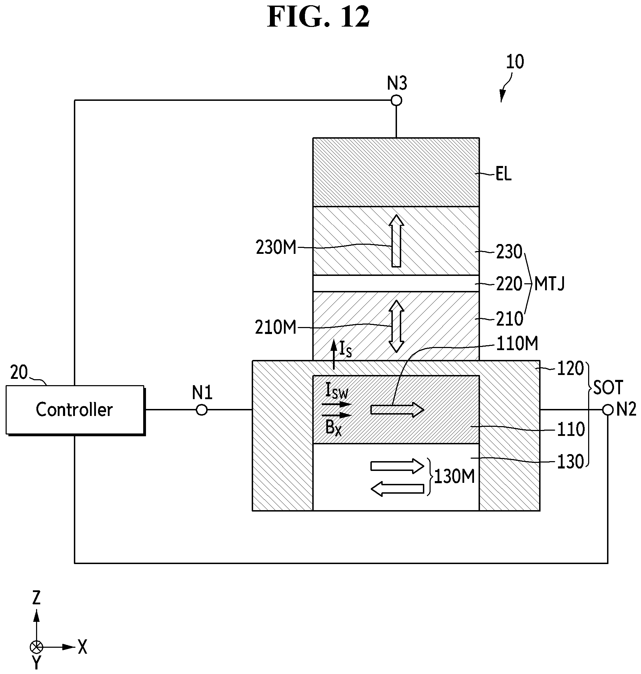

Referring to FIG. 12, in a probabilistic bit device according to some embodiments, the antiferromagnetic pattern 130 and the ferromagnetic pattern 110 may be disposed on a portion of the conductive pattern 120. The antiferromagnetic pattern 130 and the ferromagnetic pattern 110 may be aligned with the magnetic tunnel junction pattern MTJ. The antiferromagnetic pattern 130 and the ferromagnetic pattern 110 may overlap with the magnetic tunnel junction pattern MTJ in the third direction Z. The conductive pattern 120 may cover a side surface of each of the ferromagnetic pattern 110 and the antiferromagnetic pattern 130.

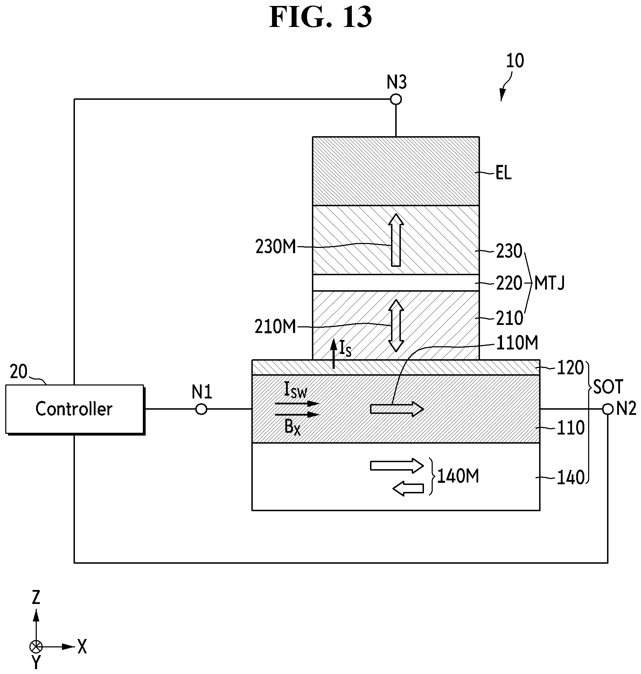

FIG. 13 is a diagram for illustrating a probabilistic bit device according to some embodiments. For convenience of description, contents duplicate with those as described above using FIGS. 1 to 8 are briefly described or descriptions thereof are omitted. Referring to FIG. 13, in a probabilistic bit device according to some embodiments, the spin orbit torque pattern SOT may further include a peripheral magnetic pattern 140. The ferromagnetic pattern 110 may be disposed between the conductive pattern 120 and the peripheral magnetic pattern 140.

The peripheral magnetic pattern 140 may have in-plane magnetic anisotropy. The magnetization direction 140M of the peripheral magnetic pattern 140 may be an in-plane direction X. For example, the peripheral magnetic pattern 140 may include at least one of CoGd, CoFeGd, CoTb, CoFeTb, iron oxides, and yttrium iron garnet (YIG).

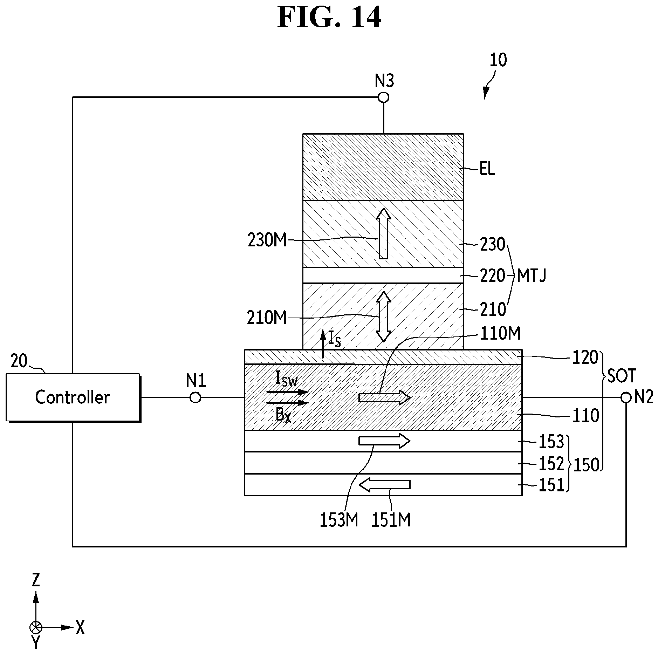

FIG. 14 is a diagram for illustrating a probabilistic bit device according to some embodiments. For convenience of description, contents duplicate with those as described above using FIGS. 1 to 8 are briefly described or descriptions thereof are omitted. Referring to FIG. 14, in a probabilistic bit device according to some embodiments, the spin orbit torque pattern SOT may further include a combined antiferromagnetic pattern 150. The ferromagnetic pattern 110 may be disposed between the conductive pattern 120 and the combined antiferromagnetic pattern 150.

The combined antiferromagnetic pattern 150 may include a first ferromagnetic pattern 151, a non-magnetic conductive pattern 152, and a second ferromagnetic pattern 153 that are sequentially stacked. The second ferromagnetic pattern 153 may be disposed between the non-magnetic conductive pattern 152 and the ferromagnetic pattern 110. Each of the first ferromagnetic pattern 151 and the second ferromagnetic pattern 153 may have in-plane magnetic anisotropy. The magnetization direction 151M of the first ferromagnetic pattern 151 may be the same as the magnetization direction 110M of the ferromagnetic pattern 110. The magnetization direction 151M of the first ferromagnetic pattern 151 may be a negative first direction X, and the magnetization direction 153M of the second ferromagnetic pattern 153 may be a positive first direction X. The magnetization intensity of the magnetization direction 151M of the first ferromagnetic pattern 151 may be equal to the magnetization intensity of that of the second ferromagnetic pattern 153. The non-magnetic conductive pattern 152 may include, for example, Ru.

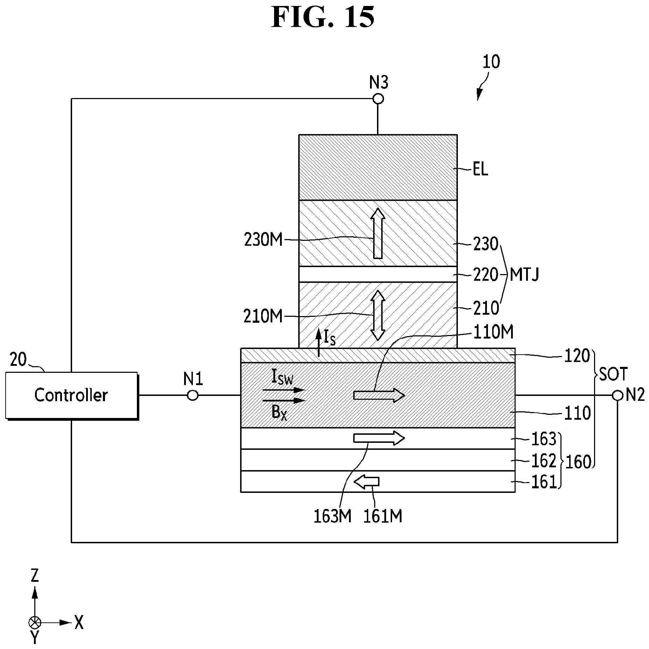

FIG. 15 is a diagram for illustrating a probabilistic bit device according to some embodiments. For convenience of description, contents duplicate with those as described above using FIGS. 1 to 8 are briefly described or descriptions thereof are omitted. Referring to FIG. 15, in a probabilistic bit device according to some embodiments, the spin orbit torque pattern SOT may further include a combined peripheral magnetic pattern 160. The ferromagnetic pattern 110 may be disposed between the conductive pattern 120 and the combined peripheral magnetic pattern 160.

The composite peripheral magnetic pattern 160 may include a first ferromagnetic pattern 161, a non-magnetic conductive pattern 162, and a second ferromagnetic pattern 163 that are sequentially stacked. The second ferromagnetic pattern 163 may be disposed between the non-magnetic conductive pattern 162 and the ferromagnetic pattern 110. Each of the first ferromagnetic pattern 161 and the second ferromagnetic pattern 163 may have in-plane magnetic anisotropy. The magnetization direction 161M of the first ferromagnetic pattern 161 may be the same as the magnetization direction 110M of the ferromagnetic pattern 110. The magnetization direction 161M of the first ferromagnetic pattern 161 may be a negative first direction X, and the magnetization direction 163M of the second ferromagnetic pattern 163 may be a positive first direction X. The magnetization intensity of the magnetization direction 161M of the first ferromagnetic pattern 161 may be different from the magnetization intensity of that of the second ferromagnetic pattern 163. The non-magnetic conductive pattern 162 may include, for example, Ru.

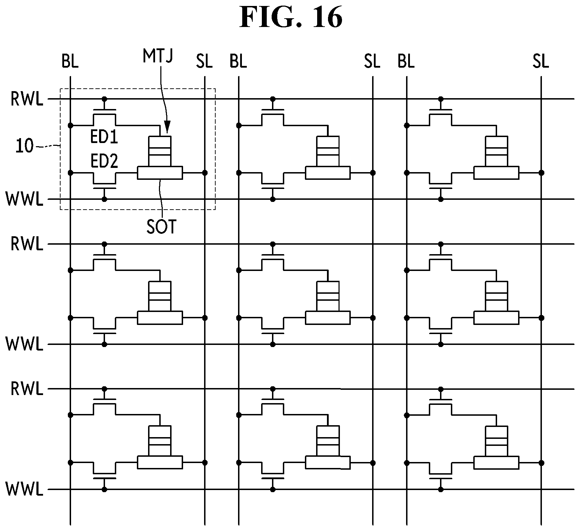

FIG. 16 is a diagram for illustrating a cell array of a magnetic memory element according to some embodiments. For convenience of description, contents duplicate with those as described above using FIGS. 1 to 15 are briefly described or descriptions thereof are omitted. Referring to FIG. 16, the cell array of the magnetic memory element according to some embodiments includes a plurality of write word-lines WWL, a plurality of read word-lines RWL, a plurality of bit-lines BL, a plurality of source lines SL and a plurality of memory cells 10.

The memory cells 10 may be arranged along a plurality of rows and a plurality of columns. The memory cells 10 in each row may be connected to a pair of a read word-line RWL and a write word-line WWL. The memory cells 10 in each column may be connected to a pair of a source line SL and a bit-line BL. In some embodiments, the memory cell 10 may include the magnetic tunnel junction pattern MTJ, the spin orbit torque pattern SOT, a first electronic element ED1, and a second electronic element ED2.

The first electronic elements ED1 of the memory cells 10 in each row may be commonly connected to the corresponding read word-line RW. The second electronic elements ED2 of the memory cells 10 in each row may be commonly connected to the corresponding writing word-line WWL. The spin orbit torque patterns SOT of the memory cells 10 in each column may be commonly connected to the corresponding source line SL, and the first electronic elements ED1 and the second electronic elements ED2 of the memory cells 10 in each column may be commonly connected to the corresponding bit-line BL.

The first electronic element ED1 may be connected to and disposed between the magnetic tunnel junction pattern MTJ and the bit-line BL. A gate electrode of the first electronic element ED1 may be connected to the read word-line RWL and may be controlled by the read word-line RWL. The second electronic element ED2 may be connected to and disposed between a first end of the spin orbit torque pattern SOT and the bit-line BL. A gate electrode of the second electronic element ED2 may be connected to and controlled by the write word-line WWL. The source line SL may be connected to a second end of the spin orbit torque pattern SOT. Each of the first and second electronic elements ED1 and ED2 may include at least one of a transistor and a diode. In some embodiments, each of the first and second electronic elements ED1 and ED2 may include a transistor.

The memory cell 10 corresponds to the memory cell 10 as described above using FIGS. 1 to 15. For example, the first node N1 of the spin orbit torque pattern SOT described above using FIGS. 1 to 15 may be connected to a source/drain of the second electronic element ED2. The second node N2 of the spin orbit torque pattern SOT described above using FIGS. 1 to 15 may be connected to the source line SL. The third node N3 described above using FIGS. 1 to 15 may be connected to a source/drain of the first electronic element ED1.

During a read operation of the selected memory cell 10, the first electronic element ED1 may be turned on and the second electronic element ED2 may be turned off through the read word-line RWL. During a read operation, the read current I_{R} in FIG. 1 may flow from the bit-line BL to the source line SL. The read current I_{R} may flow through a portion of the spin orbit torque pattern SOT and the magnetic tunnel junction pattern MTJ. The read current I_{R} in FIG. 1 may flow through the magnetic tunnel junction pattern MTJ in a direction perpendicular to an interface between the spin orbit torque pattern SOT and the magnetic tunnel junction pattern MTJ. In contrast, during a write operation of the selected memory cell 10, the second electronic element ED2 may be turned on and the first electronic element ED1 may be turned off through the write word-line WWL. Accordingly, the in-plane current Isw in FIG. 1 may flow through the spin orbit torque pattern SOT.

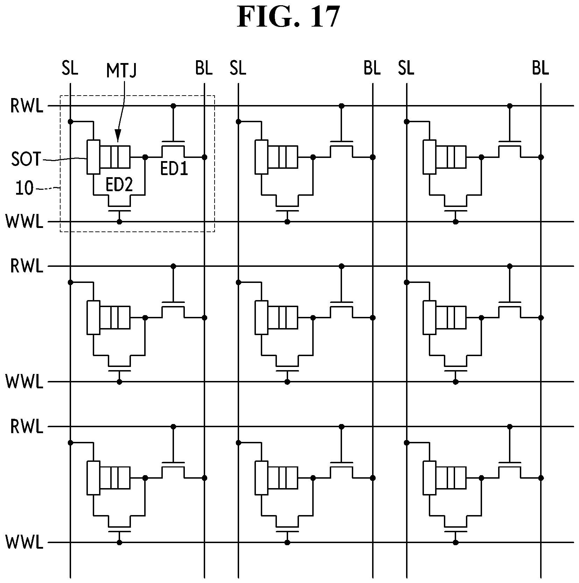

FIG. 17 is a diagram for illustrating the cell array of a magnetic memory element according to some embodiments. For convenience of description, contents duplicate with those as described above using FIGS. 1 to 16 are briefly described or descriptions thereof are omitted. Referring to FIG. 17, in the cell array of the magnetic memory element according to some embodiments, the second electronic element ED2 may be connected to and disposed between the magnetic tunnel junction pattern MTJ and the first end of the spin orbit torque pattern SOT. The gate electrode of the second electronic element ED2 may be connected to the write word-line WWL and may be controlled by the write word-line WWL. The first electronic elements ED1 of the memory cells MC in each column may be commonly connected to the corresponding bit-line BL.

The memory cell 10 corresponds to the memory cell 10 as described above using FIGS. 1 to 15. For example, the first node N1 of the spin orbit torque pattern SOT described above using FIGS. 1 to 15 may be connected to the source/drain of the second electronic element ED2. The second node N2 of the spin orbit torque pattern SOT described above using FIGS. 1 to 15 may be connected to the source line SL. The third node N3 described above using FIGS. 1 to 15 may be connected to the source/drain of the first electronic element ED1 and the source/drain of the second electronic element ED2.

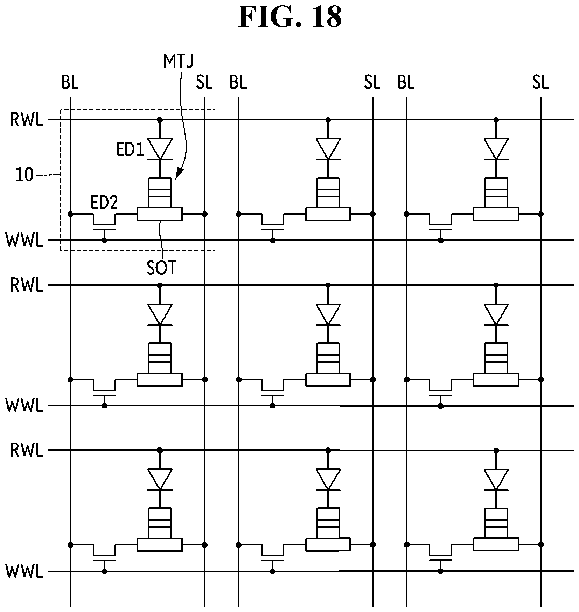

FIG. 18 is a diagram for illustrating the cell array of a magnetic memory element according to some embodiments. For convenience of description, contents duplicate with those as described above using FIGS. 1 to 16 are briefly described or descriptions thereof are omitted. Referring to FIG. 18, in the cell array of a magnetic memory element according to some embodiments, the first electronic element ED1 may include a transistor, and the second electronic element ED1, ED2 may include a diode.

A conventional software-based random number generation device may generate random numbers using a mid square method, a linear congruential method, etc. Because these random numbers are pseudorandom numbers with periodicity and a correlation between random numbers and can be predicted using machine learning, etc. the conventional software-based random number generation device is vulnerable to security.

The probabilistic bit device according to some embodiments as described above using FIGS. 1 to 18 may generate unpredictable true random numbers. The probabilistic bit device according to some embodiments as described above using FIGS. 1 to 18 may be used for a probabilistic computing device. Using probabilistic bits generated by the probabilistic bit device according to some embodiments, the probabilistic computing device can solve problems that cannot be solved by conventional computing devices using deterministic bits, and Non-deterministic complete/hard problem, and may be used for optimization using Boltzmann Machine in Machine Learning, Classical Annealing Problem, Invertible Boolean Logic, or Quantum Boltzmann Law.

Although embodiments of the present disclosure have been described with reference to the accompanying drawings, the present disclosure is not limited to the above embodiments, but may be implemented in various different forms. A person skilled in the art may appreciate that the present disclosure may be practiced in other concrete forms without changing the technical spirit or essential characteristics of the present disclosure. Therefore, it should be appreciated that the embodiments as described above is not restrictive but illustrative in all respects.

## Claims

1. A probabilistic bit device, comprising:
a spin orbit torque (SOT) pattern including a stacked combination of a ferromagnetic pattern having in-plane magnetic anisotropy and a conductive pattern on the ferromagnetic pattern; and
a magnetic tunnel junction (MTJ) pattern on the SOT pattern, the MTJ pattern including a stacked combination of a free magnetic pattern having perpendicular magnetic anisotropy, a barrier pattern, and a pinned magnetic pattern having perpendicular magnetic anisotropy; and
a controller configured to provide an in-plane current with a predetermined first magnitude and a magnetic field with a predetermined second magnitude to the SOT pattern, in an in-plane direction that is parallel to an upper surface of the ferromagnetic pattern; and
wherein each of the first magnitude and the second magnitude corresponds to a predetermined probability at which a magnetization direction of the free magnetic pattern is a specific direction.

2. The device of Claim 1, wherein the controller is configured to provide the in-plane current with the first magnitude and the magnetic field with the second magnitude to the ferromagnetic pattern, so that the probability is 50%.

3. The device of Claim 1, wherein the SOT pattern further includes an antiferromagnetic pattern; and wherein the ferromagnetic pattern extends between the antiferromagnetic pattern and the conductive pattern.

4. The device of Claim 3, wherein the conductive pattern at least partially covers a side surface of the ferromagnetic pattern and a side surface of the antiferromagnetic pattern.

5. The device of Claim 3, wherein the conductive pattern extends in the in-plane direction; and wherein the ferromagnetic pattern and the antiferromagnetic pattern extend on a portion of the conductive pattern and overlap the magnetic tunnel junction pattern.

6. The device of Claim 1, wherein the SOT pattern further includes a peripheral magnetic pattern; and wherein the ferromagnetic pattern extends between the peripheral magnetic pattern and the conductive pattern.

7. The device of Claim 1, wherein the SOT pattern further includes a combined antiferromagnetic pattern; and wherein the ferromagnetic pattern extends between the combined antiferromagnetic pattern and the conductive pattern.

8. The device of Claim 1, wherein the SOT pattern further includes a combined peripheral magnetic pattern; and wherein the ferromagnetic pattern extends between the combined peripheral magnetic pattern and the conductive pattern.

9. The device of Claim 1, wherein at least one of the first magnitude and the second magnitude is predetermined based on at least one of a thickness of the barrier pattern and a material of the barrier pattern.

10. The device of Claim 1, wherein at least one of the first magnitude and the second magnitude is predetermined based on at least one of a thickness of the free magnetic pattern and a material of the free magnetic pattern.

11. The device of Claim 1, wherein at least one of the first magnitude and the second magnitude is predetermined based on at least one of a thickness of the ferromagnetic pattern and a material of the ferromagnetic pattern.

12. A probabilistic bit device, comprising:
a memory cell including a ferromagnetic pattern, a conductive pattern, a free magnetic pattern, a barrier pattern, and a pinned magnetic pattern sequentially stacked; and
a controller configured to provide an in-plane current and a magnetic field to the ferromagnetic pattern;
wherein a magnetization direction of the ferromagnetic pattern is an in-plane direction and a magnetization direction of the pinned magnetic pattern is fixed and is a perpendicular direction;
wherein a magnetization direction of the free magnetic pattern is a perpendicular direction and is variable based on the in-plane current and the magnetic field.

13. The device of Claim 12, wherein the controller is configured to control a magnitude of the in-plane current and a magnitude of the magnetic field.

14. The device of Claim 12, wherein the controller is configured to provide the in-plane current and the magnetic field in the in-plane direction.

15. The device of Claim 12, wherein each of the ferromagnetic pattern, the free magnetic pattern, and the pinned magnetic pattern includes at least one of iron (Fe), cobalt (Co), nickel (Ni), boron (B), silicon (Si), zirconium (Zr), platinum (Pt), terbium (Tb), palladium (Pd), copper (Cu), and tungsten (W).
